Europäisches Patentamt

European Patent Office

Office européen des brevets

(19)

(11) Numéro de publication : **0 133 121**
**B1**

(12) **FASCICULE DE BREVET EUROPÉEN**

(45) Date de publication du fascicule du brevet :
27.05.87

(21) Numéro de dépôt : **84401543.8**

(22) Date de dépôt : **20.07.84**

(51) Int. Cl.⁴ : **C 23 C 14/24, C 23 C 14/56**

(54) **Dispositif d'évaporation sous vide.**

(30) Priorité : 26.07.83 FR 8312329

(43) Date de publication de la demande :
13.02.85 Bulletin 85/07

(45) Mention de la délivrance du brevet :
27.05.87 Bulletin 87/22

(84) Etats contractants désignés :
**DE GB NL**

(56) Documents cités :
**DE-A- 1 621 267**
**FR-A- 2 466 513**
**US-A- 2 551 389**
**US-A- 3 703 155**

(73) Titulaire : **Allovon, Michel**
**6, rue A.J. Caron**
**F-94110 Arcueil (FR)**

**Goldstein, Léon**
**32, rue de la Monesse**
**F-92310 Sevres (FR)**

(72) Inventeur : **Allovon, Michel**
**6, rue A.J. Caron**
**F-94110 Arcueil (FR)**
Inventeur : **Goldstein, Léon**
**32, rue de la Monesse**
**F-92310 Sevres (FR)**

(74) Mandataire : **Mongrédien, André et al**
**c/o BREVATOME 25, rue de Ponthieu**
**F-75008 Paris (FR)**

## Description

La présente invention a pour objet un dispositif d'évaporation sous vide. Elle trouve une application notamment dans les installations d'épitaxie par jet moléculaire.

Une installation d'évaporation sous vide, servant par exemple à la fabrication de semiconducteurs par épitaxie par jets moléculaires (en abrégé E.J.M.) comprend généralement une enceinte principale réunie à des moyens de pompage (pompes primaire et secondaire), et contenant les substrats à traiter, et une ou plusieurs cellules d'évaporation dans lesquelles on trouve le ou les matériaux à évaporer.

Pour permettre la recharge de ces cellules en divers matériaux, sans casser le vide de l'enceinte principale, il a été mis au point des installations dans lesquelles la cellule d'évaporation à recharger est amovible et reliée à l'enceinte principale par l'intermédiaire d'un soufflet métallique. Lorsque le soufflet est comprimé, la cellule se trouve en position normale d'évaporation dans l'enceinte ; lorsque le soufflet est étiré, la cellule se trouve rétractée hors de l'enceinte principale, dans une chambre annexe de petites dimensions. Cette chambre peut être séparée de l'enceinte principale par l'action d'une vanne étanche à l'ultra-vide.

Une telle installation permet de recharger la cellule en ne remettant à l'atmosphère que la chambre annexe.

Bien que satisfaisantes à certains égards, de telles installations présentent des inconvénients dûs à la course très importante qu'il est nécessaire de donner au soufflet (plus de 500 mm). Cette longueur entraîne en effet :

un coût élevé, dû tant au prix du soufflet par lui-même qu'au prix du système de guidage et de translation, qui doit être très précis pour assurer un alignement correct sur une grande distance,

un risque de pollution de l'enceinte par l'effet de dégazages du soufflet de grande longueur,

un poids élevé

un encombrement important, gênant l'accès aux autres cellules.

L'invention a justement pour but de remédier à ces inconvénients. A cette fin, elle préconise l'utilisation d'un dispositif qui permet de réduire considérablement la course du soufflet qui tombe à environ 50 mm, soit le 1/10e de la valeur qu'on trouve dans l'art antérieur. Le prix de l'installation, les risques de dégazage, l'encombrement et le poids se trouvent alors considérablement réduits.

Cette réduction de la longueur du soufflet est rendue possible par l'utilisation d'un tube chauffant fixe reliant l'enceinte principale à la chambre annexe, permettant de faire fonctionner la cellule d'évaporation dans la chambre annexe, et de canaliser les vapeurs produites jusque dans la chambre principale. Ce tube possède une première extrémité engagée dans l'enceinte principale et une seconde extrémité débouchant sur la chambre annexe. Cette seconde extrémité est munie d'une pièce apte à recevoir en appui la cellule d'évaporation lorsque celle-ci est en position avancée. Le tiroir de la vanne d'étanchéité vient s'insérer entre cette pièce d'extrémité et la cellule d'évaporation lorsque celle-ci est en position rétractée. De cette manière, la course de la cellule entre ses deux positions extrêmes et, par conséquent, la course du soufflet, sont limitées à l'espace nécessaire à la fermeture de la vanne.

Le dispositif de l'invention est particulièrement avantageux dans le cas des procédés mettant en œuvre des basses températures (moins de 500 °C environ) et utilisant des matériaux volatils comme l'arsenic, le phosphore, des matériaux semiconducteurs de type III-V, ou plus généralement tous éléments des colonnes IIB, V et VI de la classification périodique. C'est d'ailleurs justement avec ces matériaux que le problème de la recharge d'une installation de traitement se pose avec le plus d'acuité.

Les caractéristiques de l'invention apparaîtront mieux après la description qui suit, d'exemples de réalisation donnés à titre explicatif et nullement limitatif. Cette description se réfère à des dessins annexés sur lesquels :

la figure 1 représente, de façon schématique, le dispositif de l'invention,

la figure 2 montre la partie concernant la cellule rechargeable en position rétractée,

la figure 3 montre, en coupe, la pièce d'extrémité solidaire du tube chauffant.

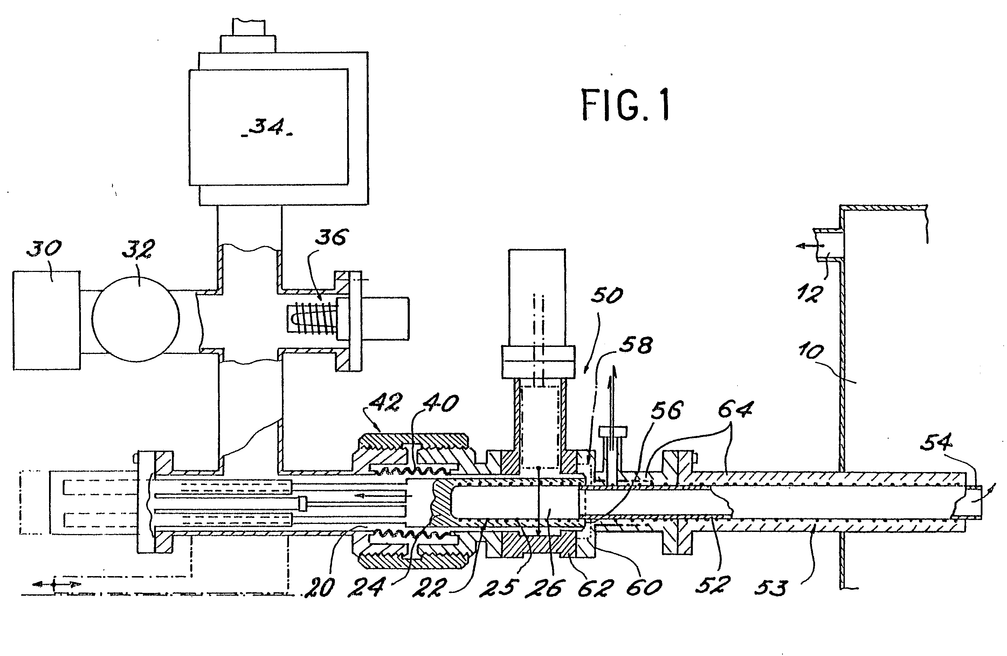

L'installation représentée sur la figure 1 comprend, essentiellement, d'une part, une enceinte principale 10, où a lieu la croissance épitaxiale (sur des substrats non représentés), cette enceinte étant reliée, par un conduit 12, à des moyens de pompage non représentés, et d'autre part, une chambre annexe 20 contenant une cellule d'évaporation 22 constituée d'un bloc chauffant 24 percé d'une cavité 26 dans laquelle se trouve le matériau à évaporer. Ce bloc est pourvu d'une résistance de chauffage 25.

Cette chambre annexe est reliée à des moyens de pompage autonomes constitués par une pompe primaire 30, associée à une vanne d'isolement 32, et une pompe ionique 34. Une jauge 36 permet de mesurer le vide.

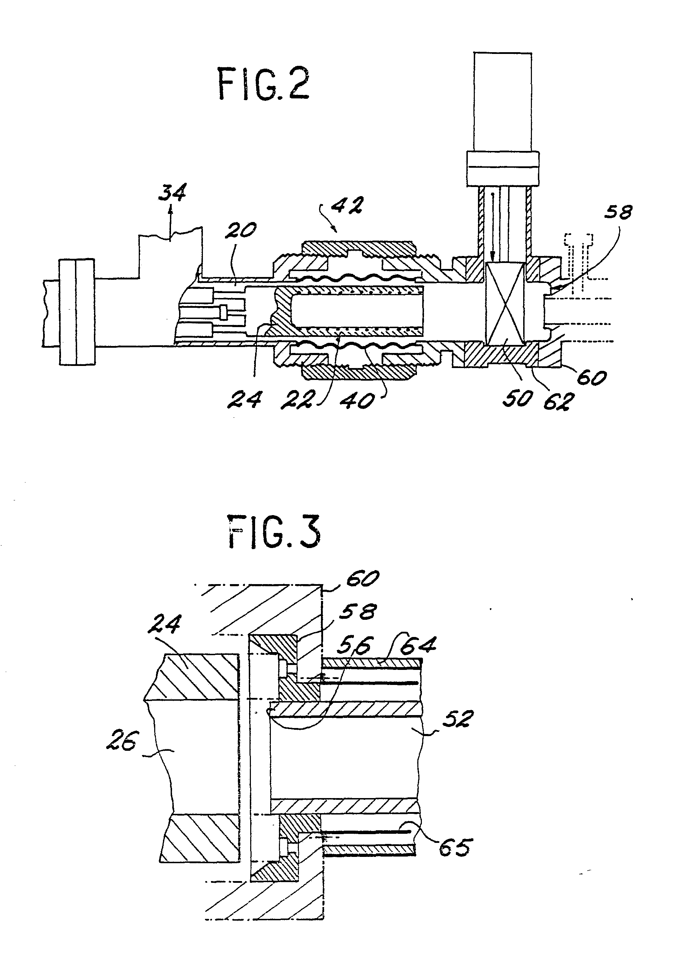

La cellule 22 est rétractable par le jeu de moyens mécaniques constitués essentiellement par un soufflet 40 associé à un mécanisme 42 de guidage de ce soufflet. La figure 1 montre la cellule en position avancée et la figure 2 cette même cellule mais en position rétractée. Une vanne à tiroir 50 permet d'isoler l'enceinte principale 10 de la chambre annexe 20 lorsque la cellule est rétractée (figure 2).

Selon la caractéristique essentielle de l'invention, l'enceinte 10 et la chambre 20 sont réunies par un tube 52 muni d'un filament chauffant 53. Ce tube possède une première extrémité 54 qui pénètre dans l'enceinte 10 et une seconde extrémité 56 qui débouche sur la chambre 20. Cette seconde extrémité est solidaire d'une pièce 58 (dont un détail est représenté sur la figure 3) fixée à un support 60 rendu solidaire du corps 62 de la vanne. Le tube 52 peut être entouré d'un écran thermique 65, l'ensemble étant logé dans le tube de maintien mécanique 64.

La figure 3 montre, de manière plus détaillée, la forme de ces différentes pièces au voisinage de la pièce d'extrémité 58. On note que cette pièce entoure le tube chauffant sur la partie qui pénètre dans la chambre annexe. Cette pièce est destinée principalement à assurer une certaine étanchéité entre la cellule 22 et le tube chauffant 52, pour éviter qu'une partie du matériau évaporé ne vienne se déposer sur la vanne 50, et un isolement thermique entre les pièces chaudes (cellule et tube) et le support extérieur 60 lié au tube 64.

Le rôle essentiel du tube 52 est de canaliser le flux de matériau évaporé, depuis la cellule d'évaporation 22 jusqu'à l'enceinte de traitement 10 en empêchant, par sa température élevée, le dépôt de ce matériau avant les substrats. Mais ce tube peut jouer également un autre rôle, qui est de permettre le craquage thermique de certains produits. Cette seconde fonction nécessite naturellement une température plus élevée, et l'aménagement de l'intérieur du tube 52 avec, par exemple, des chicanes. De telles chicanes, ou obstacles, peuvent par ailleurs être introduits dans le tube pour prévenir une focalisation excessive du flux gazeux.

Une comparaison entre les figures 1 et 2 montre clairement que le déplacement maximal de la cellule d'évaporation est de l'ordre de la largeur du tiroir de la vanne 50. Dans l'invention, la cellule reste dans la chambre 20 même en position avancée et n'a pas, comme dans l'art antérieur, à être introduite dans l'enceinte principale 10. De ce fait, le soufflet 40 peut posséder une course qui n'est qu'un peu supérieure à cette largeur, soit environ 50 mm, contre 500 dans l'art antérieur.

A titre explicatif, le tube 52 peut être en silice, avec un filament 53 en tantale. L'écran thermique 65 peut être également en tantale. La pièce d'extrémité 58 peut être en alumine, le support 60 en inox, avec passages de courant pour le filament 53. Le soufflet est de préférence métallique, et la chambre annexe 20 en acier inoxydable. Le tube chauffant 52 peut être aussi constitué d'un tube métallique entouré d'un filament chauffant isolé électriquement du tube.

En ce qui concerne les organes annexes de pompage ou les vannes, un matériel RIBER a été utilisé avec succès par les demandeurs : pompe ionique P1-25 de 25 l/s pour la pompe 34, vanne d'isolement W 38S pour la vanne 32, vanne à tiroir VTA 38 pour la vanne 50, chambre 2300 pour l'enceinte 10, cellule CBN 125-L pour la cellule 24.

Il va de soi que la description qui précède ne se rapporte à l'épitaxie par jet moléculaire qu'à titre explicatif et que l'invention peut trouver des applications plus vastes, dans toute installation mettant en œuvre une évaporation sous vide.

## Revendications

1. Dispositif d'évaporation sous vide comprenant une enceinte principale de traitement (10) reliée à une chambre annexe (20) contenant une cellule d'évaporation de matériau (22), cette cellule étant fixée à un organe de déplacement à soufflet étanche (40) apte à déplacer la cellule entre une première position avancée vers l'enceinte principale et une seconde position rétractée, une vanne d'étanchéité (50) munie d'un tiroir étant prévue pour isoler, dans cette seconde position, l'enceinte principale (10) de la chambre annexe (20), le matériau de la cellule d'évaporation pouvant ainsi être changé sans remise à l'air de l'enceinte principale, ce dispositif étant caractérisé par le fait qu'il comprend un tube chauffant fixe (52) reliant l'enceinte principale (10) à la chambre annexe (20), ce tube (52) possédant une première extrémité (54) engagée dans l'enceinte principale (10) et une seconde extrémité (56) débouchant sur la chambre annexe (20), cette seconde extrémité (56), étant munie d'une pièce d'extrémité (58), réalisée en un matériau isolant thermiquement assurant la continuité mécanique et l'isolement thermique avec la pièce support (60), et apte à recevoir en appui la cellule d'évaporation lorsque celle-ci est en position avancée, le tiroir de la vanne d'étanchéité (50) venant s'insérer entre cette pièce d'extrémité (58) et la cellule d'évaporation (22) lorsque celle-ci est en position rétractée, la course de la cellule entre ses deux positions extrêmes et, par conséquent, la course du soufflet (40) étant ainsi limitées à l'espace nécessaire à la fermeture de la vanne (50).

2. Dispositif selon la revendication 1, caractérisé par le fait que le tube chauffant est constitué d'un tube isolant, par exemple, en silice (52) entouré d'un filament chauffant (53), par exemple en tantale.

3. Dispositif selon l'une quelconque des revendications 1 et 2, caractérisé par le fait que le tube chauffant (52) est entouré d'un écran thermique (65).

4. Dispositif selon la revendication 1, caractérisé en ce que la pièce de raccordement de l'extrémité (56) du tube chauffant (52) avec le support (60) est en alumine.

5. Dispositif selon l'une quelconque des revendications 1 à 3, caractérisé en ce que le tube chauffant (52) est aménagé en son intérieur à l'aide de chicanes ou d'obstacles pour prévenir une focalisation excessive du flux des vapeurs qui y circulent.

6. Dispositif selon l'une quelconque des revendications 1 à 4, caractérisé en ce que le tube chauffant (52) est aménagé en son intérieur à l'aide de chicanes ou d'obstacles pour permettre le craquage des vapeurs qui y circulent.

7. Dispositif selon l'une quelconque des revendications 1, 3 à 6, caractérisé en ce que le tube chauffant (52) est constitué d'un tube métallique, entouré d'un filament chauffant isolé électriquement du tube.

## Claims

1. Vacuum evaporation device comprising a main treatment vessel (10) connected to a subsidiary chamber (20) containing a material evaporation cell (22), said cell being fixed to a fluid-tight bellows movement means (40) adapted to move the cell between a first position advanced in the direction of the main vessel and a second retracted position, a sealing valve (50) provided with a slide being so arranged that in said second position it isolates the main vessel (10) from the subsidiary chamber (20), the material of the evaporation cell thus being able to be changed without reconnecting the main vessel to the atmosphere, said device being characterized in that it comprises a fixed heating tube (52) connecting the main vessel (10) to the subsidiary chamber (20), said tube (52) having a first end (54) engaged in the main vessel (10) and a second end (56) leading into the subsidiary chamber (20), said second end (56) being provided with an end member (58) made of a thermal insulating material providing mechanical continuity and thermal insulation with the support member (60) and being adapted to receive and support the evaporation cell when the latter is in the advanced position, the slide of the sealing valve (50) taking up position between said end member (58) and the evaporation cell (22) when the latter is in the retracted position, the travel of the cell between its two end positions and consequently the travel of the bellows (40) thus being limited to the space required for closing the valve (50).

2. Device according to Claim 1, characterized by the fact that the heating tube consists of an insulating tube (52), for example of silica, surrounded by a heating filament (53), for example of tantalum.

3. Device according to either of Claims 1 and 2, characterized by the fact that the heating tube (52) is surrounded by a thermal shield (65).

4. Device according to Claim 1, characterized in that the member connecting the end (56) of the heating tube (52) to the support (60) is of alumina.

5. Device according to any one of Claims 1 to 3, characterized in that the heating tube (52) is provided in its interior with baffles or obstacles to prevent excessive focusing of the flow of vapours circulating in it.

6. Device according to any one of Claims 1 to 4, characterized in that the heating tube (52) is provided in its interior with baffles or obstacles permitting the cracking of the vapours circulating in it.

7. Device according to any one of Claims 1 and 3 to 6, characterized in that the heating tube (52) is composed of a metallic tube surrounded by a heating filament electrically insulated in relation to the tube.

## Patentansprüche

1. Vakuumverdampfungsvorrichtung mit einer Hauptbehandlungskammer (10), die mit einer Zusatzkammer (20) verbunden ist, die eine Materialverdampfungszelle (22) enthält, wobei die Zelle an einem mit einem dichten Balg (40) versehenen Schiebeteil befestigt ist, um so die Zelle zwischen einer ersten in Richtung zur Hauptkammer vorgeschobenen Stellung und einer zweiten zurückgezogenen Stellung zu verschieben, und mit einem vakuumdichten Ventil (50), das einen Einschub aufweist, um in der zweiten Stellung die Hauptkammer (10) von der Zusatzkammer (20) zu isolieren, so daß das Material der Verdampfungszelle ausgewechselt werden kann, ohne daß Luft in die Hauptkammer eindringt, dadurch gekennzeichnet, daß die Vorrichtung ein feststehendes Heizrohr (52) aufweist, das die Hauptkammer (10) mit der Zusatzkammer (20) verbindet, wobei dies Rohr (52) ein erstes Ende (54) aufweist, das in die Hauptkammer (10) eingreift und ein zweites Ende (56) aufweist, das in der Zusatzkammer (20) mündet, wobei das zweite Ende (56) mit einem Endstück (58) versehen ist, welches aus einem thermisch isolierenden Material besteht, das eine mechanische Dauerverbindung und thermische Isolierung mit einer Halterung (60) gewährleistet und auf dem sich die Verdampfungszelle abstützt, wenn diese in der vorgeschobenen Stellung ist, und wobei sich der Einschub des vakuumdichten Ventils (50) zwischen dieses Endstück (58) und die Verdampfungszelle (22) schiebt, wenn diese in der zurückgezogenen Stellung ist, wobei der Weg der Zelle zwischen ihren beiden Extremstellungen und demzufolge der Weg des Balges (40) auf den Raum beschränkt ist, der zum Schließen des Ventils (50) erforderlich ist.

2. Vorrichtung nach Anspruch 1, dadurch gekennzeichnet, daß das Heizrohr aus einem isolierenden Rohr besteht, z. B. aus Silikat (52), das von einem Heizdraht (53) z. B. aus Tantal umgeben ist.

3. Vorrichtung nach einem der Ansprüche 1 und 2, dadurch gekennzeichnet, daß das Heizrohr (52) von einem thermischen Schirm (65) umgeben ist.

4. Vorrichtung nach Anspruch 1, dadurch gekennzeichnet, daß das Verbindungsteil des Endes (56) des Heizrohrs (52) mit der Halterung (60) aus Aluminiumoxid besteht.

5. Vorrichtung nach einem der Ansprüche 1 bis 3, dadurch gekennzeichnet, daß das Heizrohr (52) in seinem Inneren mit Leitblechen oder Hindernissen versehen ist, um eine übermäßige Konzentration der in ihm zirkulierenden Dampfströme zu vermeiden.

6. Vorrichtung nach einem der Ansprüche 1 bis 4, dadurch gekennzeichnet, daß das Heizrohr (52) in seinem Inneren mit Leitblechen oder Hindernissen versehen ist, um ein Cracken der in ihm zirkulierenden Dämpfe zu ermöglichen.

7. Vorrichtung nach einem der Ansprüche 1, 3 bis 6, dadurch gekennzeichnet, daß das Heizrohr (52) aus einem Metallrohr besteht, das von einem elektrisch gegenüber dem Rohr isolierten Heizdraht umgeben ist.

FIG.1

# FIG.2

# FIG.3